# EUROPEAN PATENT APPLICATION

(11) **EP 3 666 920 A1**
(43) Date of publication of application: **17.06.2020**
(21) Application number: 19215586.9
(22) Date of filing: 12.12.2019
(51) Int. Cl.: C23C 14/04, C23C 16/04, G03F 1/20, G03F 7/12, H01L 51/00, G03F 1/00

(54) **METAL MASK, METHOD OF FABRICATING THE SAME, AND METHOD OF FABRICATING DISPLAY PANEL**

(30) Priority: 14.12.2018 KR 20180162090
(71) Applicant: Samsung Display Co., Ltd., Gyeonggi-Do (KR)
(72) Inventor: MOON, Youngmin, Gyeonggi-do (KR); IM, Sungsoon, Gyeonggi-do (KR)
(74) Representative: Shearman, James Ward

(57) **Abstract**

A metal mask includes: at least one cell region, and a plurality of holes defined in the at least one cell region, wherein the at least one cell region comprises at least two metallic materials comprising iron and nickel, each metallic material having a laser absorption ratio of about 30% or higher.

## Description

### BACKGROUND

### FIELD

Embodiments of the invention relate generally to a metal mask, a method of fabricating the same, and a method of fabricating a display panel and, more specifically, to a metal mask with improved process reliability, a method of fabricating the same, and a method of fabricating a display panel.

### DISCUSSION OF THE BACKGROUND

A display panel includes a plurality of pixels. Each of the pixels includes a driving element such as a transistor, and a display element such as an organic light emitting diode. The display element may be formed by stacking an electrode and a light-emitting pattern on a substrate.

To form the light-emitting pattern on a specific region, a mask, in which a penetration hole is defined, is used to pattern a light-emitting layer. The light-emitting pattern is formed on a region of the substrate exposed by the penetration hole of the mask. A shape of the light-emitting pattern is determined by a shape of the penetration hole.

The above information disclosed in this Background section is only for understanding of the background of the inventive concepts, and, therefore, it may contain information that does not constitute prior art.

### SUMMARY

Metal masks constructed according to the principles and embodiments of the invention and methods of fabricating a display panel according to the principles of the invention provide an impurity-free metal mask to improve reliability and to reduce a defect of a light-emitting pattern in a process of fabricating a display panel. For example, the metal mask according to some implementations of the invention is formed of metallic materials having similar laser absorption ratios such as iron (Fe) or nickel (Ni) and does not contain aluminium (Al) and magnesium (Mg), which act as a contaminant or an impurity to the desired properties of iron (Fe) or nickel (Ni). Accordingly, a method of fabricating a display panel according to some implementations of the invention reduces the defect of the light-emitting pattern EP when forming a light-emitting pattern of the display panel and improves process reliability.

In addition, methods of fabricating a metal mask according to the principles of the invention provide a metal mask with high process reliability. For example, the method of fabricating a metal mask according to some implementations of the invention can improve processability of the metal mask since the metal mask is formed of metallic materials having similar laser absorption ratios. Accordingly, it may be possible to reduce defects in fabricating the metal mask.

According to some particularly advantageous implementations of the invention the metallic materials used to form the metal mask may have a laser absorption ratio of about 30% or higher and/or the difference between laser absorption ratios of the metallic materials may be less than about 20%.

Additional features of the inventive concepts will be set forth in the description which follows, and in part will be apparent from the description, or may be learned by practice of the inventive concepts.

According to one aspect of the invention, a metal mask includes: at least one cell region, and a plurality of holes (*e.g*. penetration holes) defined in the at least one cell region, wherein the at least one cell region comprises at least two metallic materials comprising iron and nickel, each metallic material having a laser absorption ratio of about 30% or higher.

The difference between laser absorption ratios of each of the metallic materials may be less than about 20%.

The metallic materials may not contain an appreciable amount of aluminium or magnesium.

The metallic materials may not contain appreciable amounts of sulfur.

The iron and the nickel may include an iron-nickel alloy.

The content of nickel in the iron-nickel alloy may range from about 30% to about 40%.

According to another aspect of the invention, there is provided a method of fabricating a metal mask. The method includes the steps of: forming a thin metal film containing iron and nickel from an electrolytic solution, processing the thin metal film to form a metal substrate, and forming a metal mask having a plurality of penetration holes by irradiating a laser upon the metal substrate.

The step of forming of the metal substrate may include the steps of melting the thin metal film and rolling the melted thin metal film to form the metal substrate.

The content of nickel in the metal substrate may range from about 30% to about 40%.

The electrolytic solution may include an iron compound and a nickel compound.

The thin metal film may include an iron-nickel alloy.

The step of forming of the thin metal film may include the steps of forming a first thin metal film containing iron from a first electrolytic solution containing an iron compound, and forming a second thin metal film containing nickel from a second electrolytic solution containing a nickel compound, the second electrolytic solution being different from the first electrolytic solution.

The step of forming of the metal substrate may further include the step of mixing the first thin metal film and the second thin metal film. The metal substrate may be formed by processing the mixed first and second thin metal films.

The step of forming of the metal substrate may further include the step of performing a desulfurization step to remove sulfur from the thin metal film.

The metal mask may be formed of metallic materials, whose absorption ratios to the laser are higher than or equal to about 30%.

The metal substrate may not contain appreciable amounts of aluminium, magnesium, and sulfur.

According to still another aspect of the invention, there is provided a method of fabricating a display panel. The method includes the steps of providing a first substrate, disposing a metal mask (*e.g.* a metal mask according to the present invention) including iron and nickel materials without appreciable amounts of aluminium or magnesium, the metal mask having a plurality of penetration holes on the first substrate, forming a plurality of light-emitting patterns corresponding to the penetration holes on the first substrate, removing the metal mask, and forming a display panel by forming an upper electrode to cover the light-emitting patterns.

The metal mask may not contain appreciable amounts of sulfur.

The display panel may include a plurality of pixels, and the light-emitting patterns may be disposed in the pixels, respectively.

The first substrate may include a plurality of lower electrodes spaced apart from each other. The metal mask may be disposed such that the penetration holes are overlapped with the lower electrodes, respectively.

It is to be understood that both the foregoing general description and the following detailed description are explanatory and are intended to provide further explanation of the invention as claimed.

At least some of the above and other features of the invention are set out in the claims.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the inventive concepts.
FIG. 1 is a perspective view of an embodiment of a metal mask constructed according to the principles of the invention.
FIGS. 2A, 2C, 2D, and 2E are perspective views schematically illustrating a method of fabricating a display panel using a mask according to the principles of the invention, and FIG. 2B is an enlarged view of a specific region XX' in FIG. 2A.
FIGS. 3A to 3C are sectional views schematically illustrating some steps of a process of fabricating a display panel using a mask according to an embodiment of the invention.
FIG. 4 is a flow chart illustrating an embodiment of a method of fabricating a metal mask according to the principles of the invention.
FIG. 5A is a sectional view of an embodiment of a first step of fabricating a metal mask shown in FIG. 4.
FIG. 5B is a sectional view of an embodiment of a second step of fabricating a metal mask shown in FIG. 4.
FIGS. 6A and 6B are sectional views of an embodiment of third and fourth steps of fabricating a metal mask shown in FIG. 4.
FIG. 7A is an enlarged image of a portion of a mask according to a comparative embodiment.
FIG. 7B is an image of the portion of FIG. 7A taken using a heat sensing camera.
FIG. 8A is an enlarged image of a portion of a mask constructed according to an embodiment of the invention.
FIG. 8B is an image of the portion of FIG. 8A, taken using a heat sensing camera.
FIG. 9 is a flow chart illustrating another embodiment of a method of fabricating a metal mask according to the principles of the invention.

### DETAILED DESCRIPTION

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods employing one or more of the inventive concepts disclosed herein. It is apparent, however, that various embodiments may be practiced without these specific details or with one or more equivalent arrangements. In other instances, well-known structures and devices are shown in block diagram form in order to avoid unnecessarily obscuring various embodiments. Further, various embodiments may be different, but do not have to be exclusive. For example, specific shapes, configurations, and characteristics of an embodiment may be used or implemented in another embodiment without departing from the inventive concepts.

Unless otherwise specified, the illustrated embodiments are to be understood as providing features of varying detail of some ways in which the inventive concepts may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the D1-axis, the D2-axis, and the D3-axis are not limited to three axes of a rectangular coordinate system, such as the x, y, and z - axes, and may be interpreted in a broader sense. For example, the D1-axis, the D2-axis, and the D3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Unless otherwise defined, all terms (including technical and scientific terms) used herein have the same meaning as commonly understood by one of ordinary skill in the art to which this disclosure is a part. Terms, such as those defined in commonly used dictionaries, should be interpreted as having a meaning that is consistent with their meaning in the context of the relevant art and should not be interpreted in an idealized or overly formal sense, unless expressly so defined herein.

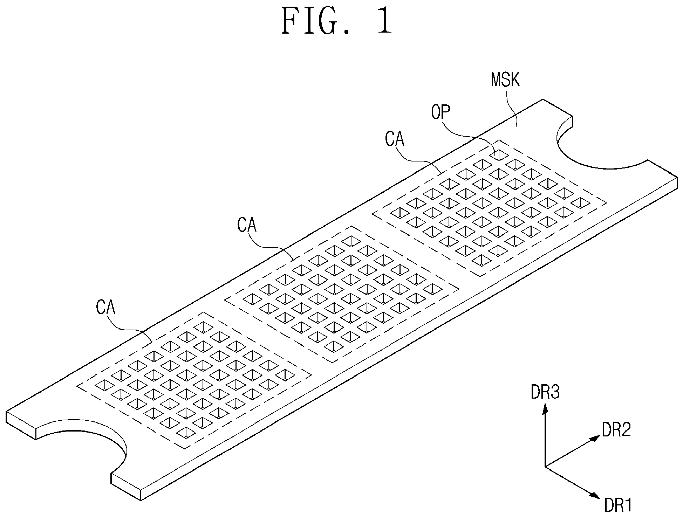

FIG. 1 is a perspective view of an embodiment of a metal mask constructed according to the principles of the invention. Hereinafter, an embodiment of the invention will be described with reference to FIG. 1.

As shown in FIG. 1, a metal mask MSK may include a plurality of cell regions CA arranged in a second direction DR2. As shown in the illustrated embodiment, three cell regions CA may be spaced apart from each other, but the embodiments are not limited to this example or a specific embodiment. For example, the metal mask MSK may include more cell regions CA and/or the cell regions CA may be arranged in a first direction DR1 intersecting the second direction DR2.

A plurality of penetration holes OP may be defined in each of the cell regions CA. The penetration holes OP may be spaced apart from each other in the first direction DR1 and the second direction DR2. Each of the penetration holes OP may penetrate completely through the metal mask MSK in a thickness direction DR3 of the metal mask MSK (hereinafter, a third direction).

The metal mask MSK is formed of a plurality of metallic materials. The metal mask MSK according to the illustrated embodiment is formed of metallic materials whose laser absorption ratio is equal to or higher than about 30%. The metallic materials include at least nickel (Ni) and iron (Fe). The metallic materials may include an iron-nickel alloy. The metal mask MSK may comprise or consist of an iron-nickel alloy. The content of nickel in the iron-nickel alloy may range from about 30% to about 40%. The metal mask MSK may have a nickel content ranging from about 30% to about 40% (*e.g.* about 30% to about 40% by weight based on the total weight of the metal mask MSK). The metal mask MSK may have a nickel content ranging from about 30% to about 40% (*e.g.* about 30% to about 40% by weight based on the total weight of the metal mask MSK) and the remaining content may be iron (Bal. about 60 - about 70%). The following table 1 shows laser absorption ratios of some metals.

**[Table 1]**

| Metal | Absorption ratio |
|---|---|
| Iron (Fe) | 49.0% |
| Nickel (Ni) | 37.8% |
| Aluminium (Al) | 8.2% |
| Magnesium (Mg) | 4.8% |

Table 1 shows absorption ratios of some materials when irradiated with a laser beam having a wavelength of about 515 nm. For example, absorption ratios of materials can be calculated by measuring the transmittance ratio and reflectivity ratio of a laser irradiated on the materials. Transmittance ratio(%) and reflectivity ratio(%) can be measured by irradiating the laser in the material. The absorption ratio(%) satisfy "100 - (Transmittance ratio(%) + reflectivity ratio(%))".

As shown in Table 1, the laser absorption ratios of iron and nickel are significantly different from laser absorption ratios of aluminium and magnesium. In the case where the difference of laser absorption ratios is large during a step of processing the metal mask MSK using a laser beam, it may be difficult to precisely control the laser-processing step. In this case, there may be technical issues, such as abnormal defects during fabricating the metal mask MSK or a reduction in accuracy and precision of the laser-processing step. In this embodiment, the difference between laser absorption ratios of metallic materials constituting the metal mask MSK may be less than about 20%. Furthermore, in the metal mask MSK, metallic materials whose laser absorption ratios are less than 10% should not be contained in the metal mask MSK. For example, aluminium (Al) and magnesium (Mg) should not be contained in the metal mask MSK according to this embodiment. For example, in the metal mask MSK, the content ratio of metallic materials whose laser absorption ratios are less than about 10% may be less than about 1% (*e.g.* less than about 1% by weight based upon the total weight of the metal mask MSK). The metal mask MSK may be formed of a material containing neither an appreciable amount of aluminium (Al) nor magnesium (Mg), and may include about less than 1% (*e.g.* about less than 1% by weight based on the total weight of the metal mask MSK) of aluminium (Al) and/or less than 1% (*e.g.* about less than 1% by weight based on the total weight of the metal mask MSK) of magnesium (Mg).

According to the principles and some embodiments of the invention, the metal mask MSK may be formed of metallic materials whose laser absorption ratios are similar to each other, and thus, the penetration holes OP may be uniformly formed by the laser-processing step. Thus, it may be possible to improve processability in fabricating the metal mask MSK.

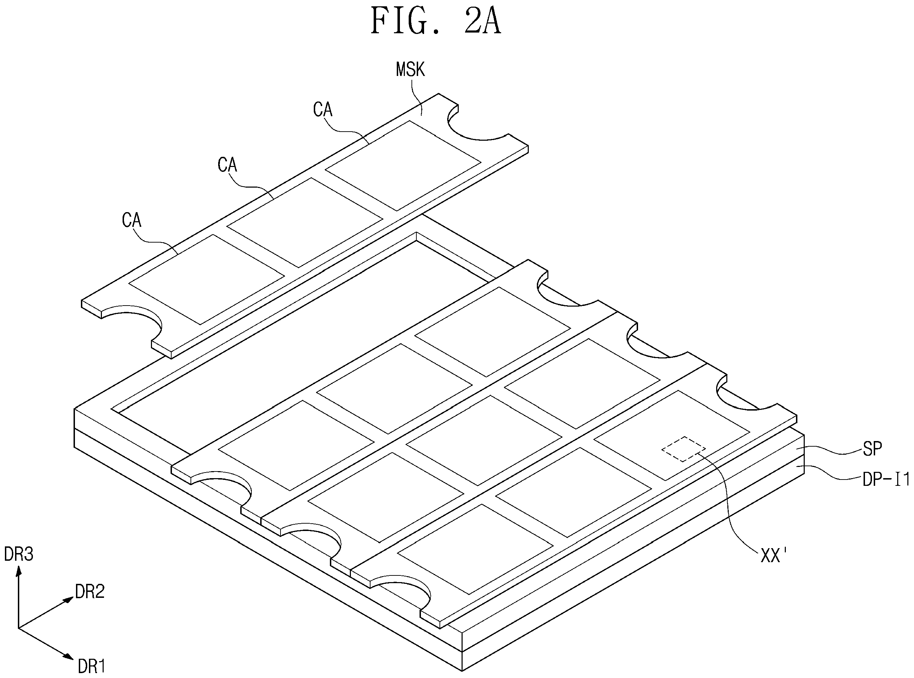

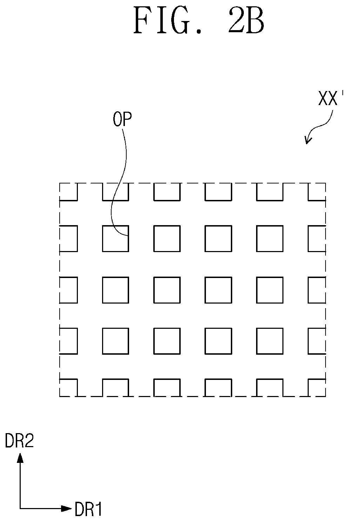

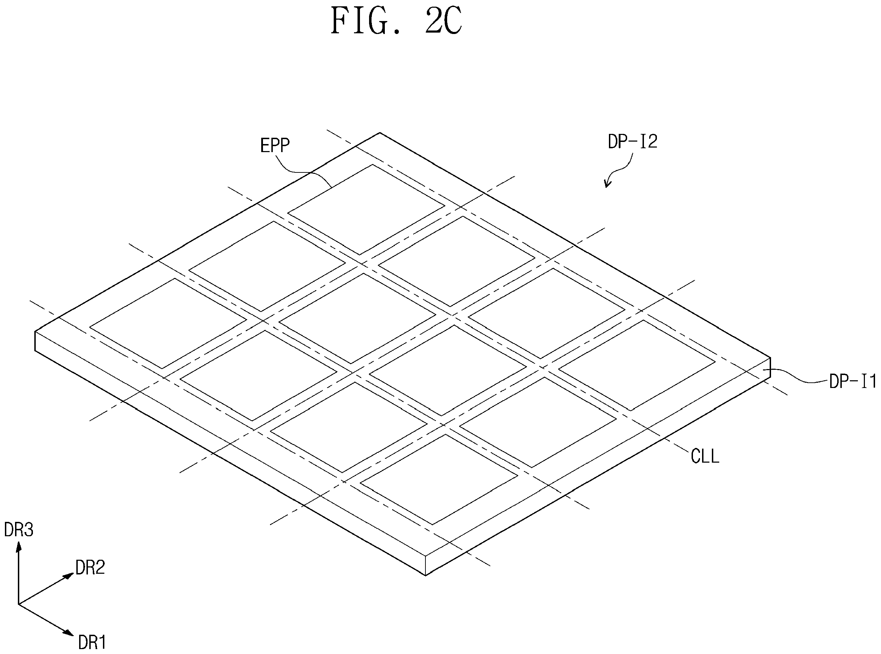

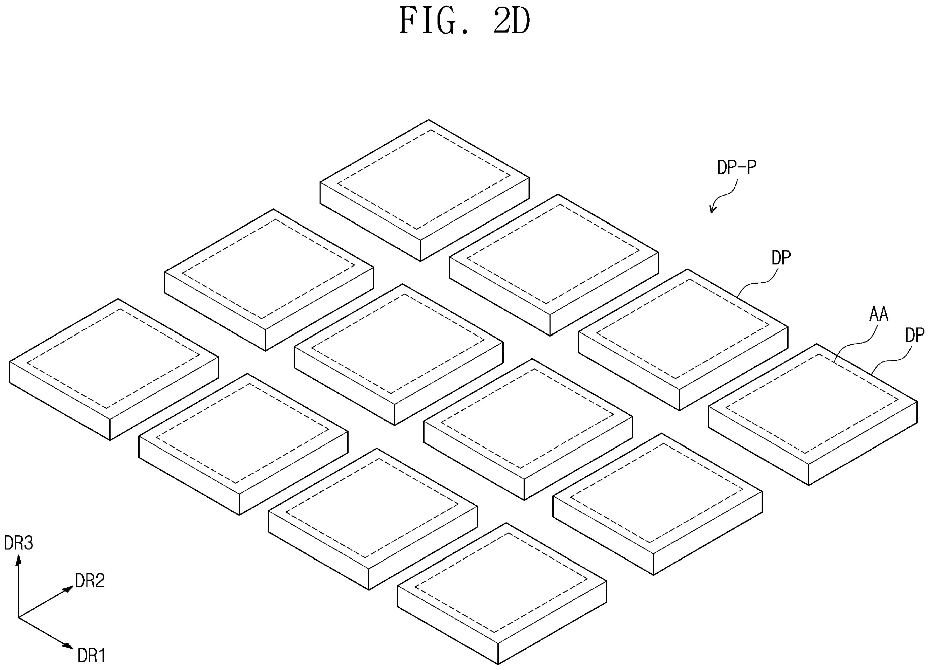

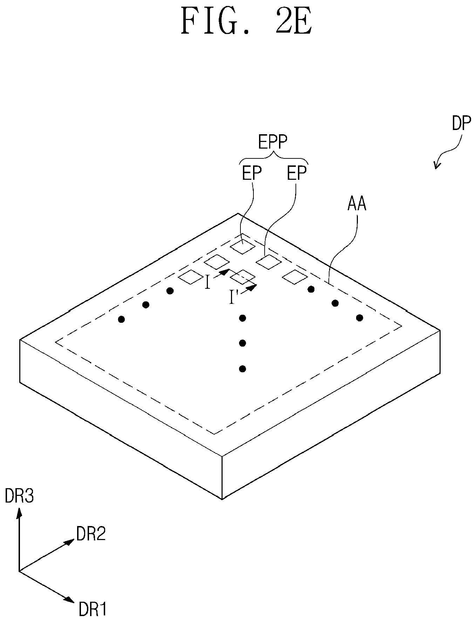

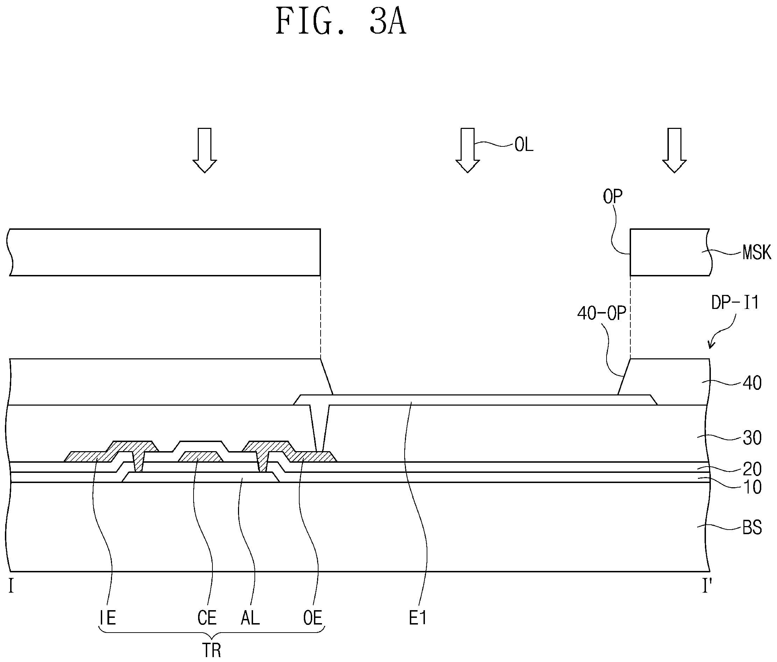

FIGS. 2A, 2C, 2D, and 2E are perspective views schematically illustrating a method of fabricating a display panel using a mask according to the principles of the invention, and FIG. 2B is an enlarged view of a specific region XX' in FIG. 2A. FIGS. 3A to 3C are sectional views illustrating some steps of a process of fabricating a display panel using a mask according to an embodiment of the invention. Specifically, FIGS. 3A to 3C illustrate sectional views of a region corresponding to a sectional view taken along a line I-I' of FIG. 2E. Hereinafter, the embodiment will be described with reference to FIGS. 2A to 3C. For concise description, an element previously described with reference to FIG. 1 may be identified by the same reference number without repeating a repetitive description thereof.

As shown in FIGS. 2A and 2B, the metal mask MSK may be disposed on an initial substrate DP-I1. In the illustrated embodiment, a plurality of the metal masks MSK may be arranged in the first direction DR1 on the initial substrate DP-I1, but the embodiments are not limited to this example. For example, a single metal mask MSK may be disposed on the initial substrate DP-I1.

In the illustrated embodiment, a supporting plate SP may be further disposed between the masks MSK and the initial substrate DP-I1. The supporting plate SP may be provided in the form of a frame exposing at least a portion of the initial substrate DP-I1. The masks MSK may be coupled to the supporting plate SP to form a single object.

A portion of the initial substrate DP-11 exposed by the supporting plate SP may be overlapped with the cell regions CA, in which the penetration holes OP of each of the masks MSK are defined. As shown in FIG. 2B illustrating an enlarged structure of a region XX', the penetration holes OP may be arranged to be spaced apart from each other in the first direction DR1 and the second direction DR2 in a regular or an irregular pattern.

In the illustrated embodiment, the supporting plate SP may prevent the masks MSK from being in direct contact with the initial substrate DP-I1. Thus, it may be possible to prevent the initial substrate DP-11 from being damaged by physical contact with the masks MSK. However, the embodiment is not limited to this example or a specific embodiment, and in an embodiment, when a display panel is fabricated, the masks MSK may be directly disposed on the initial substrate DP-11 without the supporting plate SP interposed therebetween.

Thereafter, the metal mask MSK may be removed from the initial substrate DP-I1, as shown in FIG. 2C. The initial substrate, from which the metal mask MSK is removed, will be denoted by a reference number DP-I2 and, in an embodiment, the initial substrate DP-I2 may be a structure, in which light-emitting pattern layers EPP are further formed on the initial substrate DP-I1. The light-emitting pattern layers EPP may be formed at regions corresponding to the cell regions CA. The illustrated embodiment illustrates an example, in which twelve light-emitting pattern layers EPP are spaced apart from each other. Each of the light-emitting pattern layers EPP may include a plurality of light-emitting patterns EP shown in FIG. 2E, and the light-emitting patterns EP may be formed at respective regions corresponding to the penetration holes OP.

Referring to FIGS. 2C and 2D, the initial substrate DP-I2 without the metal mask MSK may be cut along cutting lines CLL, which are defined in the initial substrate DP-I2 without the metal mask MSK, and may be divided into a plurality of panels DP-P. Each of the panels DP-P may be used as a display panel DP.

According to an embodiment, a plurality of the display panels DP-P may be formed by patterning the single initial substrate DP-I1, and thus, it may be possible to reduce process time and process cost. However, the embodiments are not limited to this example or a specific embodiment, and in an embodiment, only one display panel DP may be obtained from the initial substrate DP-I1, e.g., if the desired size of the display panel DP is large.

Referring to FIG. 2E, the display panel DP may include at least one active region AA. The active region AA may include a plurality of pixels PX. The active region AA may correspond to a region provided with the light-emitting pattern layer EPP, and the light-emitting patterns may correspond to the pixels PX, respectively. Hereinafter, the embodiment will be described with reference to FIGS. 3A to 3C.

FIG. 3A illustrates a sectional view corresponding to the initial substrate DP-I1 shown in FIG. 2A. Referring to FIG. 3A, the initial substrate DP-I1 may include a base substrate BS, a transistor TR, a lower electrode E1, and a plurality of insulating layers 10, 20, 30, and 40. In the illustrated embodiment, for convenience in illustration, some (e.g., first to fourth insulating layers 10, 20, 30, and 40) of the insulating layers are exemplarily illustrated.

The base substrate BS may include a plastic substrate, a glass substrate, a metal substrate, and so forth. The plastic substrate may include a resin. For example, the base substrate BS may be formed of or include at least one of acrylic resins, methacryl resins, polyisoprene resins, vinyl resins, epoxy resins, urethane resins, cellulose resins, siloxane resins, polyimide resins, polyamide resins, or perylene resins.

The transistor TR may be disposed on the base substrate BS. In an embodiment, a plurality of the transistors TR may be disposed in the penetration holes OP, respectively (*i.e.* the plurality of the transistors TR may not be overlapped with the penetration holes OP). For convenience of illustration, an example in which one transistor TR is disposed corresponding to one penetration hole OP, (*i.e.* the transistor TR is not overlapped with the one penetration hole OP) is shown in the illustrated embodiment. However, the embodiments are not limited to this example or a specific embodiment, and a plurality of transistors TR may be overlapped with one penetration hole OP.

The transistor TR may include a semiconductor pattern AL, a control electrode CE, an input electrode IE, and an output electrode OE. The semiconductor pattern AL may include a semiconductor material. For example, the semiconductor pattern AL may include at least one of group IV elements, group VIII elements, and metal oxides.

The control electrode CE may be disposed on a first insulating layer 10. The control electrode CE may be overlapped with the semiconductor pattern AL when viewed in a plan view and may be spaced apart from the semiconductor pattern AL in a sectional view. The control electrode CE may be spaced apart from the semiconductor pattern AL with the first insulating layer 10 interposed therebetween. However, the embodiments are not limited to this example or a specific embodiment, and in the transistor TR according to an embodiment, the semiconductor pattern AL may be disposed on the control electrode CE.

The input electrode IE and the output electrode OE may be disposed on a second insulating layer 20. The input electrode IE and the output electrode OE may be spaced apart from each other, when viewed in a plan view. The input electrode IE and the output electrode OE may penetrate the first insulating layer 10 and the second insulating layer 20 and may be coupled to the semiconductor pattern AL.

However, the embodiments are not limited to this example, and in the transistor TR according to an embodiment, the input electrode IE and the output electrode OE may be disposed below the semiconductor pattern AL or between the control electrode CE and the semiconductor pattern AL. In an embodiment, the input electrode IE and the output electrode OE may be disposed at the same level as the semiconductor pattern AL and may be in direct contact with the semiconductor pattern AL. The structure of the transistor TR may be variously changed and the embodiments are not limited to a specific structure of the transistor TR.

The lower electrode E1 may be disposed on a third insulating layer 30. The third insulating layer 30 may be disposed on the transistor TR to cover the transistor TR. The third insulating layer 30 may include an organic material and/or an inorganic material.

The lower electrode E1 may penetrate the third insulating layer 30 and may be coupled to the transistor TR. The initial substrate DP-I1 may further include an additional connection electrode, which is disposed between the lower electrode E1 and the transistor TR, and here, the lower electrode E1 may be electrically coupled to the transistor TR through the connection electrode.

A fourth insulating layer 40 may be disposed on the third insulating layer 30. An opening 40-OP may be defined in the fourth insulating layer 40. The opening 40-OP may be formed at a position corresponding to the lower electrode E1 to expose a portion of the lower electrode E1.

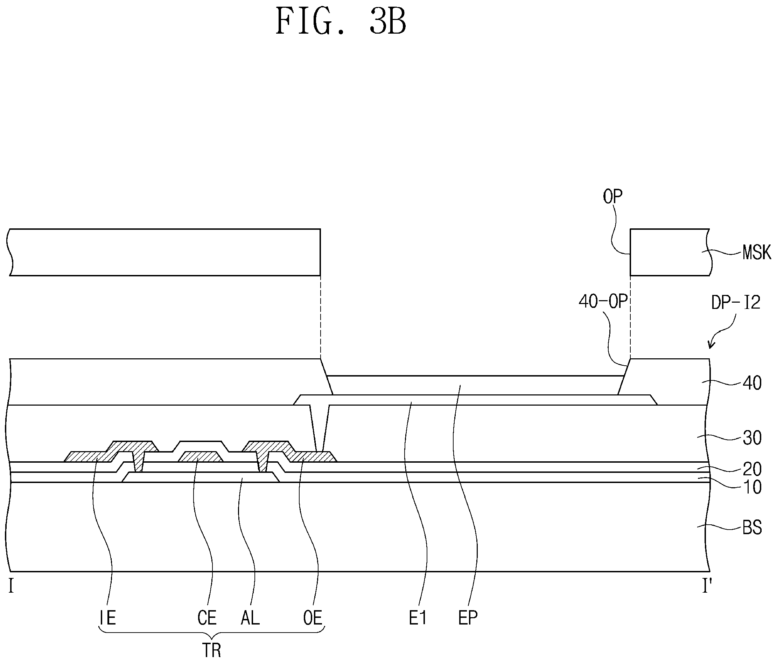

In the illustrated embodiment, the penetration hole OP of the metal mask MSK may be provided at a position corresponding to the opening 40-OP of the fourth insulating layer 40. The opening 40-OP of the fourth insulating layer 40 may be selectively patterned through the penetration hole OP of the metal mask MSK. This will be described in more detail with reference to FIG. 3B.

FIG. 3B illustrates a sectional view corresponding to FIG. 2C. Referring to FIG. 2C, light-emitting pattern layers EPP may be formed on the initial substrate DP-I1, and each of the light-emitting pattern layers EPP may include a plurality of light-emitting patterns EP shown in FIG. 2E. Further, referring to FIGS. 3A and 3B, the light-emitting pattern EP may be formed on the initial substrate DP-I1 and the light-emitting pattern EP may be formed by locally forming a patterning material OL on the initial substrate DP-I1. For example, the light-emitting pattern EP may be formed by depositing the patterning material OL on a specific region of the initial substrate DP-I1 (e.g., exposed by the penetration hole OP) using the metal mask MSK. However, the embodiments are not limited to this example or a specific embodiment. For example, if the metal mask MSK is used, the light-emitting pattern EP may be formed through a solution process or a printing process.

The patterning material OL may include a light-emitting material. For example, the patterning material OL may be formed of at least one of materials capable of emitting red, green, and blue lights and may include a fluorescent or phosphorescent material. The light-emitting material may be activated by an electrical signal to emit light of specific color. The patterning material OL may include an organic light emitting material or an inorganic light-emitting material.

In an embodiment, a plurality of the light-emitting patterns EP may be provided in openings, respectively. For convenience in illustration, an example, in which one light-emitting pattern EP is disposed in one opening 40-OP, is shown in the illustrated embodiment.

However, the embodiments are not limited to this example, and a plurality of the light-emitting patterns EP may be overlapped with one opening 40-OP. Alternatively, one light-emitting pattern EP may be overlapped with a plurality of openings. The shape of the light-emitting pattern EP may be variously changed, and the embodiments are not limited to a specific shape of the light-emitting pattern EP.

Referring to FIG. 3B, the light-emitting pattern EP may be formed in the opening 40-OP. The portion of the lower electrode E1 exposed by the opening 40-OP may be covered with the light-emitting pattern EP.

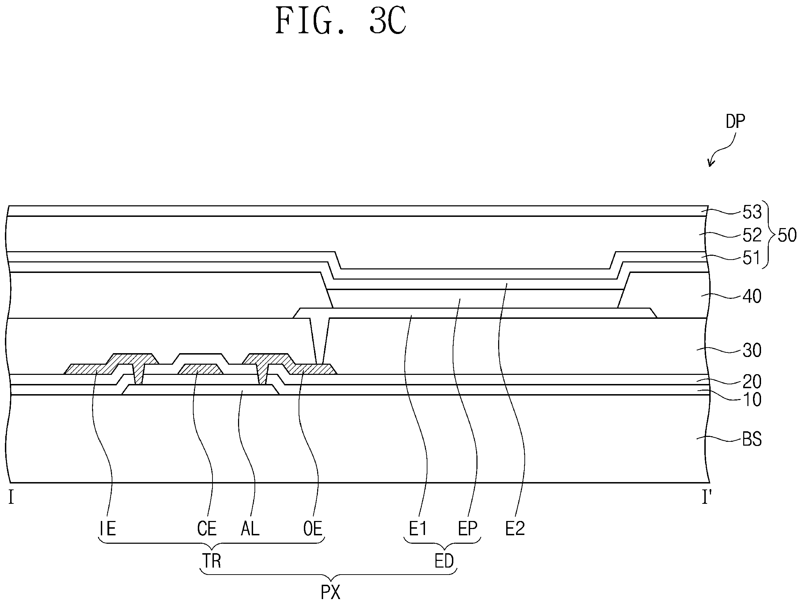

FIG. 3C illustrates a sectional view corresponding to FIG. 2E. As shown in FIG. 3C, an upper electrode E2 and an encapsulation layer 50 may be sequentially formed on the light-emitting pattern EP to form the display panel DP. The upper electrode E2 may be disposed on the light-emitting pattern EP. The upper electrode E2 is illustrated as a single object, which is overlapped with a plurality of light-emitting patterns. However, the embodiments are not limited to this example, and in an embodiment, a plurality of the upper electrodes E2 may be provided in such a way that each of them is overlapped with a corresponding one of the light-emitting patterns.

The upper electrode E2, along with the lower electrode E1 and the light-emitting pattern EP, may constitute a light-emitting device ED. The pixel PX may include the light-emitting device ED and the transistor TR. Depending on the potential difference between the upper electrode E2 and the lower electrode E1, the light-emitting pattern EP of the light-emitting device ED may be activated to emit light.

The encapsulation layer 50 may cover the light-emitting device ED. The encapsulation layer 50 may include a first inorganic layer 51, an organic layer 52, and a second inorganic layer 53. The first inorganic layer 51 and the second inorganic layer 53 may be formed of or include silicon nitride, silicon oxide, or any compound thereof. The first inorganic layer 51 and the second inorganic layer 53 may be formed by a deposition process (e.g., a chemical vapor deposition (CVD) process).

The organic layer 52 may be disposed on the first inorganic layer 51 to have a flat top surface. For example, the organic layer 52 may be disposed to cover an uneven top surface of the first inorganic layer 51 or particles on the first inorganic layer 51, and this may make it possible to prevent a top profile of the first inorganic layer 51 from affecting elements (e.g., the second inorganic layer 53) to be disposed on the organic layer 52. In addition, the organic layer 52 may relieve stress between layers in contact with each other. The organic layer 52 may be formed of or include an organic material and may be formed by a solution-based process (e.g., a spin coating process, a slit coating process, and an inkjet process).

As described above, the difference between laser absorption ratios of metallic materials constituting the metal mask MSK according to an embodiment may be less than about 20%. In addition, in the metal mask MSK, the content ratio of metallic materials whose laser absorption ratios are less than about 10% may be less than about 1% (*e.g.* less than about 1% by weight based upon the total weight of the metal mask MSK). The metal mask MSK according to the illustrated embodiment may be formed of a material containing neither an appreciable amount of aluminium (Al) nor magnesium (Mg), and may include about less than 1% (*e.g.* about less than 1% by weight based on the total weight of the metal mask MSK) of aluminium (Al) or less than 1% (*e.g.* about less than 1% by weight based on the total weight of the metal mask MSK) of magnesium (Mg) caused by process errors. Accordingly, the metallic materials that are included in the metal mask (MSK) do not contain an appreciable amount of aluminium or magnesium.

By using the metal mask MSK according to an embodiment, it is possible to selectively form a pattern in only a localized region corresponding to the penetration hole OP. In addition, the metal mask MSK does not contain aluminium (Al) and magnesium (Mg), which acts as a contaminant or an impurity to the desired laser absorption properties of iron (Fe) or nickel (Ni), and thus, the penetration hole OP may be easily and accurately formed. Accordingly, it may be possible to reduce the defect of the light-emitting pattern EP in a process of forming the light-emitting pattern EP and to improve process reliability. This will be described in more detail below.

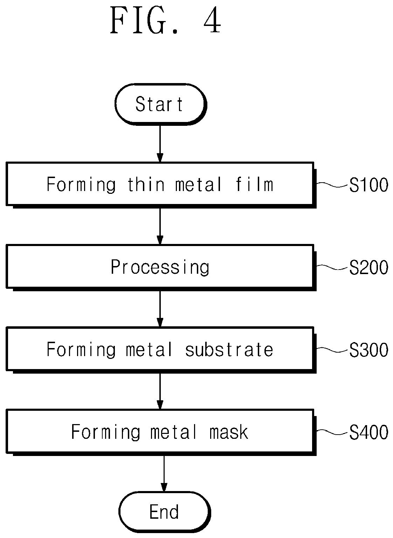

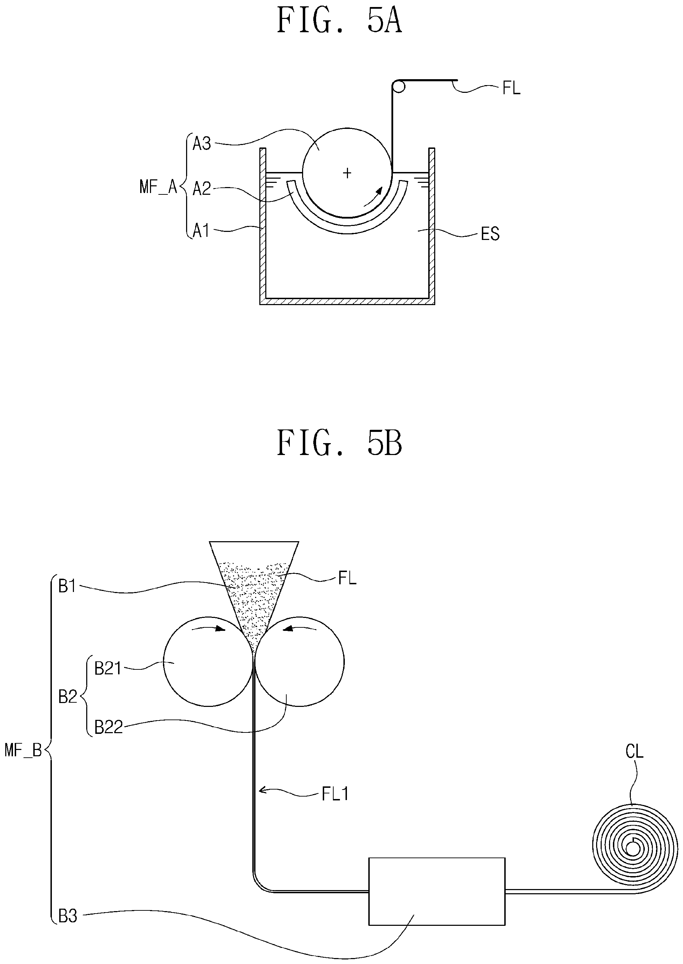

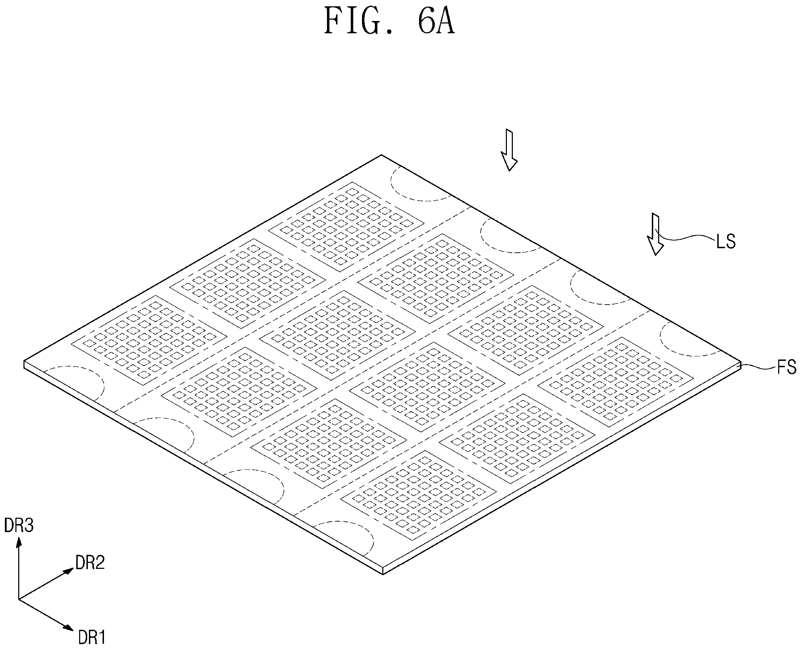

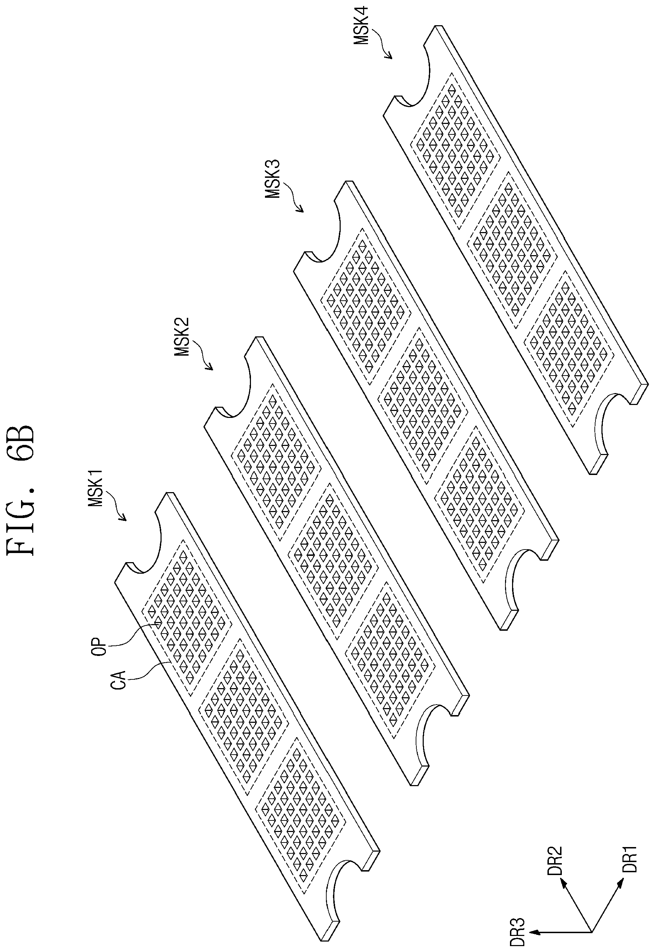

FIG. 4 is a flow chart illustrating an embodiment of a method of fabricating a metal mask according to the principles of the invention. FIG. 5A is a sectional view of an embodiment of a first step of fabricating a metal mask shown in FIG. 4, and FIG. 5B is a sectional view of an embodiment of a second step of fabricating a metal mask shown in FIG. 4. FIGS. 6A and 6B are sectional views of an embodiment of third and fourth steps of fabricating a metal mask shown in FIG. 4. Hereinafter, the embodiment will be described with reference to FIGS. 4 to 6B. For concise description, elements previously described with reference to FIGS. 1 to 3C may be identified by the same reference number without repeating a repetitive description thereof.

As shown in FIG. 4, a method of fabricating a metal mask includes a thin metal film forming step S100, a processing step S200, a metal substrate forming step S300, and a metal mask forming step S400.

FIG. 5A may correspond to the thin metal film forming step S100. Referring to FIGS. 4 and 5A, the thin metal film forming step S100 may be performed by an electroforming method. Accordingly, a thin metal film FL may be formed from an electrolytic solution ES.

In detail, the thin metal film forming step S100 may be performed using a first apparatus MF_A. The first apparatus MF_A may include an electrolytic bath A1, an anode structure A3, and a cathode structure A2. The electrolytic bath A1 may contain the electrolytic solution ES.

The electrolytic solution ES may be a liquid material. The electrolytic solution ES may include at least one of iron compounds or nickel compounds. For example, in the illustrated embodiment, the electrolytic solution ES may include both an iron compound and a nickel compound. The electrolytic solution ES may include a specific solvent with iron and nickel ions dispersed in the solvent.

The solvent may contain pure (e.g., deionized) water or ultra-pure water, but the embodiments are not limited to this example. The electrolytic solution ES may further contain an additive agent for reducing a voltage and stabilizing a reaction or a catalyst for increasing reaction velocity, but the embodiments are not limited to this example.

The anode structure A3 may be provided in a cylindrical shape, and as shown in FIG. 5A, a side surface of the cylindrical anode structure A3 may be dipped into the electrolytic solution ES. In an embodiment, the anode structure A3 may have a circular section.

The cathode structure A2 may have a shape surrounding the portion of the side surface of the anode structure A3 dipped in the electrolytic solution ES. The cathode structure A2 may have an arc-shaped section.

The cathode structure A2 may be spaced apart from the anode structure A3 by a specific distance. The cathode structure A2 may have a voltage opposite to the anode structure A3. The electrolytic solution ES may be provided in a space between the anode structure A3 and the cathode structure A2, and if a current flowing through the electrolytic solution ES is produced by a difference in voltage between the anode structure A3 and the cathode structure A2, a thin metal film FL may be precipitated or deposited on a surface of the anode structure A3.

The thin metal film FL may include an iron-nickel alloy. As the anode structure A3 rotates counter-clockwise in the direction of the arrow in FIG. 5A, the precipitated or deposited thin metal film FL may be moved along a line and may be provided to the outside.

The content ratio of nickel to iron in the thin metal film FL may be determined depending on the contents of iron and nickel compounds contained in the electrolytic solution ES. According to an embodiment, the thin metal film FL may be designed to have a nickel content ranging from about 30% to about 40% (*e.g.* about 30% to about 40% by weight based on the total weight of the thin metal film FL) and the remaining content may be iron (Bal. about 60 - about 70%).

However, the embodiments are not limited to this example, and, the composition of the thin metal film FL may be variously changed depending on the composition of the electrolytic solution ES. For example, in the case where the electrolytic solution ES contains only one or the other of iron and nickel compounds, the thin metal film FL may form an iron film or a nickel film. This will be described in more detail below.

Thereafter, as shown in FIG. 4, the processing step S200 may be performed. FIG. 5B may correspond to the processing step S200. Referring to FIGS. 4 and 5B, the processing step S200 may be performed using a rolling process. In the illustrated embodiment, the thin metal film FL may form a metal coil CL through the processing step S200.

In detail, the processing step S200 may be performed using a second apparatus MF_B. The second apparatus MF_B may include an injecting part B1, a rolling part B2, and a sintering part B3. The injecting part B1 may contain the thin metal film FL. In the illustrated embodiment, the thin metal film FL may be provided in an easily processable (e.g., melted) state or may be provided in a bulk state. The injecting part B1 may provide the thin metal film FL to the rolling part B2.

The rolling part B2 may include a first roller B21 and a second roller B22, each of which has a cylindrical shape. The first roller B21 and the second roller B22 may be spaced apart from each other by a specific distance and may be disposed to face each other. The first roller B21 and the second roller B22 may rotate in opposite directions.

For example, as shown in FIG. 5B, the first roller B21 may rotate in a clockwise direction, whereas the second roller B22 may rotate in a counterclockwise direction. The thin metal film FL provided between the first roller B21 and the second roller B22 may be compressed by pressure between the first roller B21 and the second roller B22 to form a thin intermediate metal film FL1.

The thin intermediate metal film FL1 may be processed by the sintering part B3, thereby forming the metal coil CL. The sintering part B3 may be configured to grow crystals of metal particles (e.g., nickel or iron) in the thin intermediate metal film FL1 and to remove pores from the thin intermediate metal film FL1. Thus, the metal coil CL may have a relatively dense crystal structure, compared to the thin intermediate metal film FL1. However, the embodiments are not limited to this example, and in an embodiment, the sintering part B3 may be omitted from the second apparatus MF_B.

As shown in FIG. 4, the metal mask forming step S400 may be performed after the metal substrate forming step S300. FIG. 6A may correspond to the metal substrate forming step S300 and FIG. 6B may correspond to the metal mask forming step S400.

Referring to FIGS. 4 to 6B, a plurality of the penetration holes OP may be formed in a metal substrate FS to form a metal mask. The penetration holes OP may be formed by using a laser LS.

As shown in FIG. 6A, the laser LS may be irradiated onto the metal substrate FS along cutting lines (e.g., depicted by dotted lines). The metal substrate FS may be formed by cutting the metal coil CL of FIG. 5B to a specific size. However, the embodiment is not limited to this example or a specific embodiment. For example, in an embodiment, the metal coil CL itself may be used as the metal substrate FS.

As shown in FIG. 6B, a plurality of metal masks MSK1, MSK2, MSK3, and MSK4 may be formed from one metal substrate FS. Each of the metal masks MSK1, MSK2, MSK3, and MSK4 may include a plurality of the cell regions CA, which are spaced apart from each other in the second direction DR2, and the penetration holes OP formed by using the laser LS may be formed in each of the cell regions CA.

However, the embodiments are not limited to this example or a specific embodiment, and in a metal mask fabricating method according to an embodiment, only one metal mask may be formed from each metal substrate FS. According to an embodiment, since the electroforming and rolling processes are used to fabricate a metal mask, the metal mask forming step S400 may be performed with improved process reliability.

According to an embodiment, an additional thermal treatment process may be omitted from the process of forming the metal mask MSK. Thus, it may be possible to reduce shrinkage or deformation of the metal mask MSK caused by the thermal treatment and to form the metal mask MSK with improved reliability. Furthermore, it may be possible to fabricate the metal mask MSK in a desired or designed shape.

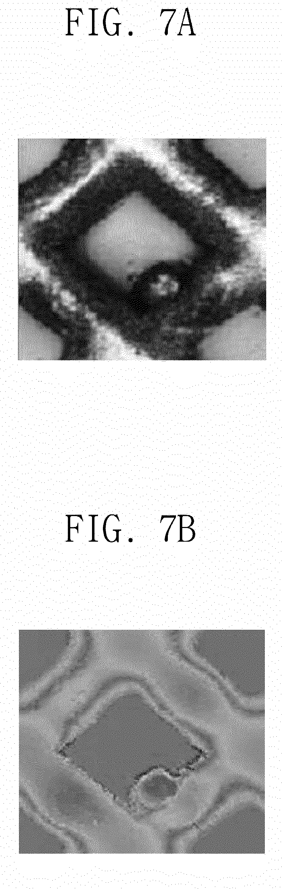

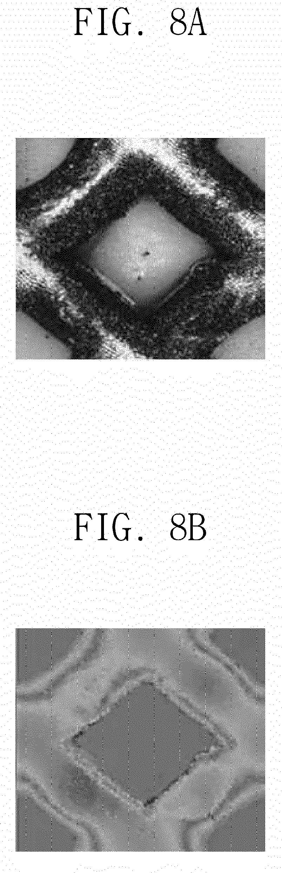

FIG. 7A is an enlarged image of a portion of a mask according to a comparative embodiment, and FIG. 7B is an image of the portion of FIG. 7A, taken using a heat sensing camera. FIG. 8A is an enlarged image of a portion of a mask constructed according to an embodiment of the invention, and FIG. 8B is an image of the portion of FIG. 8A, taken using a heat sensing camera. FIGS. 7A to 8B may correspond to one of the penetration holes OP shown in FIG. 6B. Hereinafter, the embodiment will be described with reference to FIGS. 7A to 8B.

In the comparative embodiment, the metal mask contains aluminium (Al), in addition to nickel and iron. In the comparative embodiment, a protrusion may be formed in a penetration hole, as shown in FIG. 7A. In the case where the protrusion is formed in the penetration hole, it affects a shape of the penetration hole. A portion of the penetration hole according to the comparative embodiment may be blocked by the protrusion.

Referring to FIG. 7B, the protrusion may have a laser absorption ratio different from that of a neighboring portion. The protrusion may include aluminium oxide. The aluminium has a laser absorption ratio of about 8.2% and has a laser absorptivity difference of 20% or higher, which is smaller than the laser absorption ratios of nickel and iron, whose laser absorption ratios are about 37.8% and about 49%, respectively.

Thus, a portion in which an impurity, such as aluminium, having a laser absorption ratio significantly lower than that of iron or nickel is contained may have a relatively low processability to the laser LS (e.g., see FIG. 6A). Thus, it may be difficult to uniformly form the penetration hole OP by the laser, and thus, an unprocessed or defect portion, such as the protrusion, may be formed after the laser processing step.

By contrast, according to an embodiment, the metal mask MSK may include metallic materials having laser absorption ratio of 30% or higher. For example, the metal mask MSK according to the illustrated embodiment may contain nickel (Ni) and iron (Fe), whereas aluminium (Al) and magnesium (Mg) may not be contained in the metal mask MSK according to the illustrated embodiment.

As shown in FIGS. 8A and 8B, in the metal mask MSK according to an embodiment, the penetration hole OP may be formed to have a substantially uniform shape, compared with that in the comparative embodiment described with reference to FIG. 7A. The protrusion of FIG. 7A may not be formed in the metal mask MSK according to the illustrated embodiment. In addition, the metal mask MSK according to the illustrated embodiment may have a substantially uniform heat distribution.

According to an embodiment, since the metal mask MSK is formed of metallic materials having similar laser absorption ratios, it may be possible to improve processability of the metal mask MSK. Accordingly, it may be possible to reduce defects of the metal mask MSK. That is, it may be possible to reduce the failure ratio and process costs.

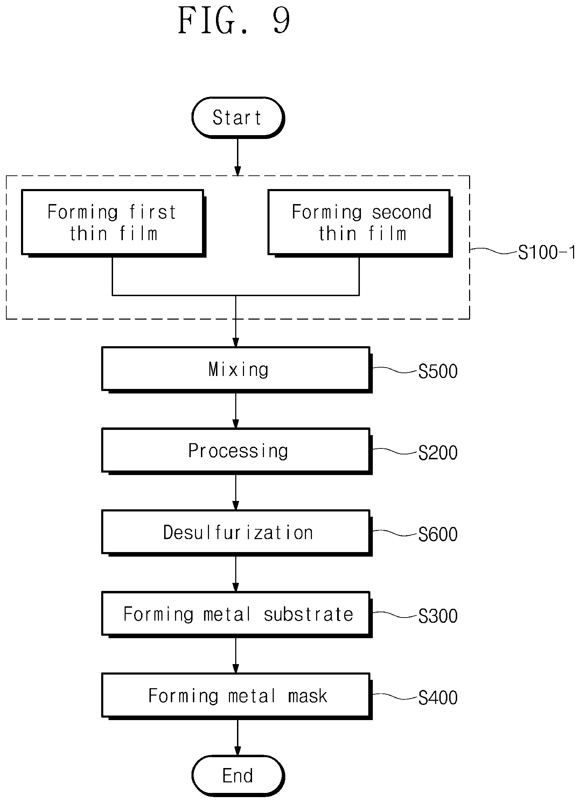

FIG. 9 is a flow chart illustrating another embodiment of a method of fabricating a metal mask according to the principles of the invention. Hereinafter, the embodiment will be described with reference to FIG. 9. For concise description, an element previously described with reference to FIGS. 1 to 8B may be identified by the same reference number without repeating a repetitive description thereof.

As shown in FIG. 9, in a method of fabricating a metal mask, a thin film forming step S 100-1 may include a step of forming a first thin film and a step of forming a second thin film. The first thin film and the second thin film may be sequentially formed by separate processes or may be independently formed.

According to the illustrated embodiment, the electrolytic solution ES (e.g., see FIG. 5A) may be separately provided as two different solutions. For example, the step of forming the first thin film may be performed using an electrolytic solution, in which an iron compound is contained, to form the first thin film containing iron, and the step of forming the second thin film may be performed using another electrolytic solution, in which a nickel compound is contained, to form the second thin film containing nickel.

Thereafter, as shown in FIG. 9, the first thin film and the second thin film may be mixed through a mixing step S500 and then may be provided to the processing step S200. Thus, the thin metal film FL (e.g., see FIG. 5B) provided to the second apparatus MF_2 shown in FIG. 5B may be replaced with the structure in which the first thin film and the second thin film are mixed. Meanwhile, the mixing ratio of the first thin film and the second thin film may be determined based upon on the desired iron and nickel contents in the metal mask MSK.

The method of fabricating a metal mask, according to an embodiment, may further include a desulfurization step S600. For example, The desulfurization step S600 can be carried out by wet desulfurization method using liquid desulfurizing agent(for example, magnesium hydroxide, sodium hydroxide, etc.) and dry desulfurization method using powder-stained desulfurization agent (for example, sodium carbonate, etc.). The desulfurization step S600 may be performed after or before at least one of the thin metal film forming step S 100-1, the mixing step S500, or the processing step S200. In the case where sulfur (S) or sulfur oxide (SO₂) is produced during the thin metal film forming step S 100-1, the mixing step S500, or the processing step S200, the sulfur or sulfur oxide may be removed by the desulfurization step S600 such that no appreciable amounts of sulfur remain. For example, the sulfur content of the metal mask MSK may be less than about 1% (*e.g.* less than about 1% by weight based upon the total weight of the metal mask MSK). Accordingly, it may be possible to prevent the metal mask MSK from being damaged by the sulfur or sulfur oxide and to improve reliability and processability of the metal mask MSK.

According to an embodiment, it may be possible to reduce the impurity content in a metal mask. In addition, it may be possible to improve processability of the metal mask and consequently to realize the metal mask with improved uniformity and high stability. Furthermore, by using the metal mask, it may be possible to reduce the failure ratio of a display panel and to fabricate a display panel with improved reliability.

Although certain embodiments and implementations have been described herein, other embodiments and modifications will be apparent from this description. Accordingly, the inventive concepts are not limited to such embodiments, but rather to the broader scope of the appended claims and various obvious modifications and equivalent arrangements as would be apparent to a person of ordinary skill in the art.

## Claims

1. A metal mask (MSK) comprising:
at least one cell region (CA), and
a plurality of holes (OP) defined in the at least one cell region (CA),
wherein the at least one cell region (CA) comprises at least two metallic materials comprising iron and nickel, each metallic material having a laser absorption ratio of about 30% or higher.

2. A metal mask (MSK) according to claim 1, wherein the difference between laser absorption ratios of the metallic materials is less than about 20%.

3. A metal mask (MSK) according to claim 1 or claim 2, wherein the metallic materials do not contain an appreciable amount of aluminium or magnesium.

4. A metal mask (MSK) according to claim 3, wherein the metallic materials do not contain appreciable amounts of sulfur.

5. A metal mask (MSK) according to any one claims 1 to 4, wherein the iron and the nickel comprises an iron-nickel alloy.

6. A metal mask (MSK) according to claim 5, wherein the content of nickel in the iron-nickel alloy ranges from about 30% to about 40%.

7. A method of fabricating a metal mask (MSK), the method comprising the steps of:
forming a thin metal film (FL) containing iron and nickel from an electrolytic solution (ES);
processing the thin metal film (FL) to form a metal substrate (FS); and
forming a metal mask (MSK) having a plurality of penetration holes (OP) by irradiating a laser (LS) upon the metal substrate (FS).

8. A method according to claim 7, wherein the step of forming of the metal substrate (FS) comprises the steps of:
melting the thin metal film (FL); and
rolling the melted thin metal film (FL) to form the metal substrate (FS).

9. A method according to claim 7 or claim 8, wherein the content of nickel in the metal substrate ranges from about 30% to about 40%.

10. A method according to any one of claims 7 to 9, wherein the electrolytic solution (ES) comprises an iron compound and a nickel compound.

11. A method according to claim 10, wherein the thin metal film (FL) comprises an iron-nickel alloy.

12. A method according to claim 7, wherein the step of forming of the thin metal film (FL) comprises the steps of:
forming a first thin metal film containing iron from a first electrolytic solution containing an iron compound; and
forming a second thin metal film containing nickel from a second electrolytic solution containing a nickel compound, the second electrolytic solution being different from the first electrolytic solution.

13. A method according to claim 12, wherein the step of forming of the metal substrate (FS) further comprises the step of mixing the first thin metal film and the second thin metal film, and
the metal substrate (FS) is formed by processing the first and second mixed thin metal films.

14. A method according to any one of claims 7 to 13, wherein the step of forming of the metal substrate (FS) further comprises the step of performing a desulfurization step to remove sulfur from the thin metal film (FL).

15. A method according to any one of claims 7 to 14, wherein the metal mask (MSK) is formed of metallic materials, whose absorption ratios to the laser are higher than or equal to about 30%.

16. A method according to claim 15, wherein the metal substrate (FS) does not contain appreciable amounts of aluminium, magnesium, and sulfur.

17. A method of fabricating a display panel (DP), the method comprising the steps of:
providing a first substrate (DP-I1);
disposing a metal mask (MSK) on the first substrate (DP-I1), wherein the metal mask (MSK) comprises iron and nickel materials without appreciable amounts of aluminium or magnesium, the metal mask (MSK) having a plurality of penetration holes (OP);
forming a plurality of light-emitting patterns (EP) corresponding to the penetration holes (OP) on the first substrate (DP-I1);
removing the metal mask (MSK); and
forming a display panel (DP) by forming an upper electrode (E2) to cover the light-emitting patterns (EP).

18. A method according to claim 17, wherein the metal mask (MSK) does not contain appreciable amounts of sulfur.

19. A method according to claim 17 or claim 18, wherein the display panel (DP) comprises a plurality of pixels (PX), and
the light-emitting patterns (EP) are disposed in the pixels (PX), respectively.

20. A method according to claim 19, wherein the first substrate (DP-I1) comprises a plurality of lower electrodes (E1) spaced apart from each other, and
the metal mask (MSK) is disposed such that the penetration holes (OP) are overlapped with the lower electrodes (E1), respectively.
